# EUROPEAN PATENT SPECIFICATION

(11) **EP 0 707 092 B1**
(45) Date of publication and mention of the grant of the patent: **08.07.1998**
(21) Application number: 95916023.5
(22) Date of filing: 20.04.1995
(51) Int. Cl.: C23C 14/06

(54) **SLIDE MEMBER AND METHOD OF ITS PRODUCTION**
GLEITSTÜCK UND VERFAHREN ZU DESSEN HERSTELLUNG
COULISSE ET SON PROCEDE DE FABRICATION

(30) Priority: 21.04.1994 JP 104993/94
(43) Date of publication of application: 17.04.1996
(73) Proprietor: KABUSHIKI KAISHA RIKEN, Chiyoda-ku Tokyo 102 (JP)
(72) Inventor: OOYA, Masaki, Kashiwazaki-shi Niigata-ken 945 (JP); TAKIGUCHI, Katsumi, Ohmiya-shi Saitama-ken 330 (JP)
(74) Representative: Serjeant, Andrew Charles
(86) International application number: JP9500782
(87) International publication number: WO9529271

(56) References cited:
- GB-A- 2 243 162
- JP-A- 1 234 559
- JP-A- 3 172 504
- JP-A- 6 093 421
- JP-A-62 087 423
- JP-A-62 120 471
- US-A- 5 205 188
- SURFACE AND COATINGS TECHNOLOGY, 30 MAY 1991, SWITZERLAND, vol. 46, no. 1, ISSN 0257-8972, pages 65-74, XP002001774 STEFFENS H -D ET AL: "Reduction of droplet emission in random arc technology"
- Microfilm of the specification and drawings annexed to the written application of Japanese Utility Model Application No. 193520/1984, (Laid-open No. 107403/1986), (Okura Shoji K.K.), 8 July 1986 (08.07.86), lines 5 to 9, page 1, lines 3 to 9, page 5.

## Description

### Technical Field

The invention relates to a sliding member such as a vane or piston ring of cast iron or steel with a coating having high strength, good adhesion, good abrasion and baking resistance.

### Background Art

A high sliding capacity is required for a sliding surface of sliding member such as a piston ring in an internal combustion engine and a vane of a compressor. A hard Cr-plating exhibits excellent properties, and has been used in the prior art. However, recently, the load on such sliding surfaces is tending to increase owing to the high output power of internal combustion engines, as a measure against waste gas, and for light weight and control. TiN, TiC and CrN coatings applied by ion-plating are coming into use.

TiN coatings produced by PVD are very hard and brittle, and have high residual stress, so their adhesion is bad. When a thick coating is used, it tends to peel off in use, so the material on which the member slides is worn away. Accordingly, as disclosed in Japanese Patent Publication No. Hei 4-19412, the piston ring matrix is formed by the following method: surface roughness is adjusted by polishing, and a very thin TiN coating is formed on the surface. After the TiN coating, no further processing is performed in principle; lapping for improving contacts is the most that is possible. A deformed layer is thus formed on the surface, and cannot be removed by ion-bombardment pretreatment before ion plating, so the adhesion of the coating to the surface is not sufficient. When the coating is thick, it is easily peeled off, while when it is thin, the durability of the sliding member is not sufficient.

### The Invention

The invention provides a sliding member as set out in claim 1.

The coating may have a mixed constitution comprising any of metallic chromium and chromium nitride; or chromium nitride; or a constitution in which the concentration of nitrogen increases continuously or stepwise from the inside to the outer surface of the coating; or an amorphous constitution.

The method of preparation comprises the first step for blasting the substrate surface to a roughness in the stated range, the second step for coating a thin layer consisting of chromium and nitrogen by ion-plating, and the third step for polishing the surface of the coating.

In principle, it is conceivable to prepare the surface of a sliding member by polishing the surface of the layer which was coated thicker taking account of the loss of the layer at the polishing step, however, this method has not been implemented, firstly because the layer is easily peeled off due to the higher internal stress of the coated layer by ion-plating compared with that of electroplating which increases according to the increase of the thickness and secondly because it is not economical to coat thicker layer, since the speed of formation of TiN or TiC layer is slow due to the slow vaporization speed of Ti.

Firstly any deformation layer present in the surface is removed by the blasting and the surface roughness is made to from 2 µm to 8 µm. When the surface roughness is 2 µm or less, the residual stress in the coating is high, and the coating adhesion is bad. When the surface roughness is 8 µm or more, the effect of a fall in residual stress in the coating is small. Time is required to make the surface fine and maintain the coating thickness, so it is inefficient. Since the deformation layer is removed physically by blasting, an active surface is obtained. The active surface cannot be maintained until the ion plating process is formed, but the activity can easily be restored by ion bombardment in the ion plating process, which makes the adhesion to the surface of the ion plated coating good. Furthermore, the increase of the contact surface with the layer caused by the increase of the roughness of the surface accelerate the adhesion to the surface. The residual stress of coating is small, so there is little peeling off tendency in the coating. The adhesion of the coating is high for these reasons, and if wearing is performed after forming the coating, the coating cannot be peeled off.

According to the present invention, the roughness of the layer is adjusted to below 0.8 µm by the polishing of the layer prepared by ion plating on the surface which was made to from 2 µm to 8 µm by removing the deformation layer.

The coating thickness is selected in connection with the surface roughness, but a thickness of at least 10 µm is required for durability. When the surface roughness is more than 0.8 µm, the material on which the member slides is adversely affected by the sliding member.

Secondly a layer consisting of chromium and nitrogen is prepared by ion plating. The reason for the selection of chromium and nitrogen is that compared with titanium, chromium has a high vapour pressure, and is easily evaporated. Accordingly the coating forms quickly in the ion plating process, and it is economically possible for the coating to be made thick for polishing. The coating comprising chromium and nitrogen has the excellent baking, wear and corrosion resistances, so it is not only suitable for the sliding member but also has low inside stress and peeling-off resistance as compared to TiN and TiC coatings. Accordingly, the coating can be made thicker and a sliding member having good durability can be obtained.

A layer consisting of chromium and nitrogen is defined as a layer consisting of Cr, Cr₂N, CrN and the mixtures thereof, in which the concentration of N increases continuously from the inside towards the outside of the layer, including a layer, the structure of which is amorphous.

### Drawings

Fig. 1 is a schematic squint view of a vane (sliding member) for a rotary compressor; and
Fig. 2 is a schematic view of ion plating apparatus for coating in a process according to the invention.

### Examples

This invention is embodied through the processes to activate the surface by blasting, to prepare a layer consisting of chromium and nitrogen by ion plating and to polish the surface by lapping.

In the blasting process, sand and air are blown out against the surface of the sliding member. Thus dirt on the surface and inhibitory substances which adhere, such as oxides, are removed and an active surface is obtained. The average surface roughness can be varied by changing the particle sizes of alumina, silicon carbide or like sand, and by changing the pressure and the number of blasts. As shown in Table 1, when the average surface roughness in 2 µm or less, the residual stress of the coating is high. When the average surface roughness is more than 2 µm, the residual stress of the coating becomes gradually lower, while when the average surface roughness is more than 8 µm, the effect of lowering the residual stress of the coating is less. However, when the surface roughness is too much, the coating thickness needs to be made thicker, and much time is needed for surface abrasion. Then the surface roughness is optimally 4 µm to 6 µm.

**Table 1**

| surface roughness | residual stress | coating thickness | coating construction |
|---|---|---|---|
| about 0.8 µm or less | 1480 MPa | 43 µm | CrN |
| about 0.8 µm to about 2.0 µm | 1400 MPa | 40 µm | CrN |
| about 2.0 µm to about 4.0 µm | 1350 MPa | 46 µm | CrN |
| about 4.0 µm to about 6.0 µm | 1320 MPa | 38 µm | CrN |
| about 6.0 µm to about 8.0 µm | 1290 MPa | 45 µm | CrN |
| about 8.0 µm or more | 1280 MPa | 42 µm | CrN |

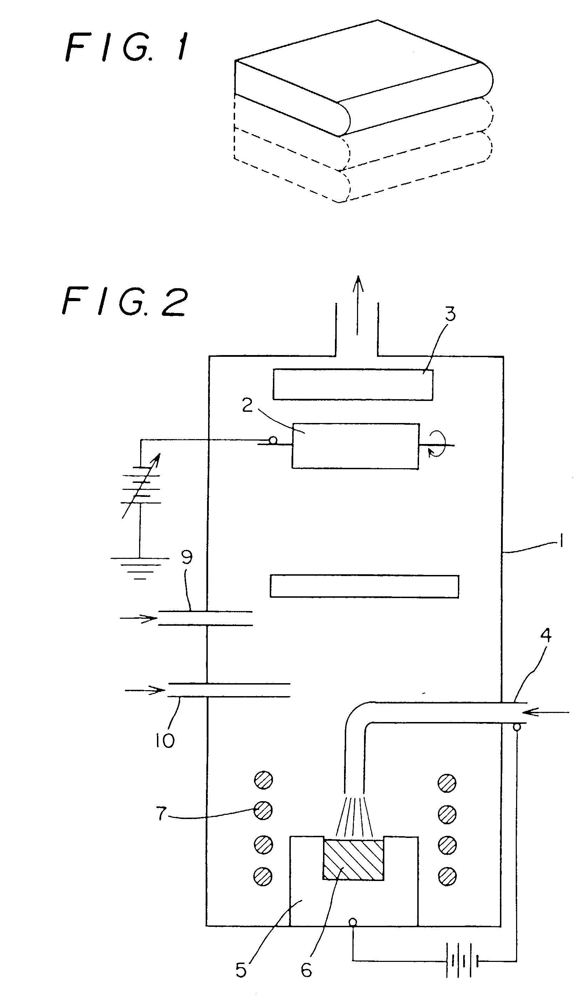

About 100 piston rings 2 (having an outer diameter of 85 x an upper-to-lower thickness of 2 mm and a diameter direction thickness of 3.1 mm) made of the steel were stacked in the upper-to-lower direction arranging outer surrounding, bundled up the both sides with nuts through a disc and set in a jig. Alternatively, the sliding surfaces of about 50 vanes for a rotary compressor made of steel (50 mm x 30 mm x 5 mm) (nitrogenated) as shown in Fig. 1 can be treated in the same way. The outer surrounding was sand blasted with two blasts of a carborundum #180 as the sand at a pressure 490 kPa to give an average surface roughness of 4.3 µm. The surface was rinsed, washed with tri-chloroethane and cleaned with steam so that the sand was fully removed. However, the sand can be removed with clean compressed air, and the washing with tri-chloroethane is not necessary, so the process can be performed according to anti-pollution measures.

The piston rings were then coated with chromium and nitrogen by an HCD ion plating process in apparatus as shown in Fig. 2. The rings were placed in the vacuum apparatus 1, which was reduced to 1 x 10⁻⁴ torr or less by a vacuum pump (not shown), and heated to about 400°C by the heater 3. After a time, argon gas was introduced up to about 1 x 10⁻² torr from an entrance 9. A direct current voltage was applied, and glow discharge and Argon ion bombardment of the surface were performed. An electron beam was developed by the hollow cathode 4 and chromium was evaporated by irradiating the metallic chromium 6 in the copper crucible 5. The electron beam was controlled by the coil 7. Nitrogen gas was introduced from an entrance 10 until the desired pressure was reached. A coating comprising amorphous chromium and nitrogen was formed on the outer surface of the rings 2 to a thickness of 20 to 60 µm.

At the coating of amorphous layer consisting of chromium and nitrogen, the heating temperature was controlled up to 200°C.

At the preparation of a layer in which the concentration of nitrogen increases continuously or stepwise from the inside to the outside of the layer, the coating may be implemented by increasing the volume of the nitrogen gas to be introduced to the level of the determined partial pressure continuously or stepwise.

Examples 1 to 6 involve various operating conditions as shown in Table 2.

**Table 2**

| | coating condition | | | | |
|---|---|---|---|---|---|
| Example No. | temperature | nitrogen partial present | amount of Ar | beam current | time |
| Example 1 | 200°C | 1.2x10⁻³ torr | 30cc | 500A | 200 minutes |
| Example 2 | 400°C | 1.0x10⁻³ torr | 30cc | 500A | 200 minutes |
| Example 3 | 400°C | 1.2x10⁻³ torr | 30cc | 500A | 200 minutes |
| Example 4 | 400°C | 1.5x10⁻³ torr | 30cc | 500A | 200 minutes |
| Example 5 | 400°C | 3.0x10⁻³ torr | 30cc | 500A | 200 minutes |
| Example 6 | 400°C | continuously raise to 3.0x10⁻³ torr | 30cc | 500A | 200 minutes |

The surface roughness of the piston rings and vanes so prepared was 0.8 µm or less. Their coatings were examined and the results are shown in Table 3. The analysis of the coating compositions was performed by EPMA, the structure analysis by X-rays. The hardness of the section of the coatings was measured with a micro Vickers Hardimeter, and the coating thickness was measured with a metallurgical microscope.

**Table 3**

| Example No. | coating thickness µm | construction | composition | hardness | peeling off coating |
|---|---|---|---|---|---|
| Example 1 | 35 µm | amorphous | Cr, N, impurity | 1712 HmV | no |
| Example 2 | 38 →µm | Cr, Cr₂N | Cr, N, impurity | 1581 HmV | no |
| Example 3 | 32 →µm | Cr₂N | Cr, N, impurity | 1676 HmV | no |
| Example 4 | 33 →µm | Cr₂N, CrN | Cr, N, impurity | 1996 HmV | no |
| Example 5 | 30 →µm | CrN | Cr, N, impurity | 1896 HmV | no |
| Example 6 | 30 →µm | outer surface is CrN | Cr, N, impurity | 1812 HmV | no |
| Comparison Example 1 | 7 →µm | TiN | Ti, N, impurity | 2400 HmV | no |
| Comparison Example 2 | 35 →µm | Cr, Cr₂N | Cr, N, impurity | 1623 HmV | yes |
| ( → means above) | | | | | |

Comparison Examples 1 and 2 involved piston rings and vanes prepared by prior art methods. In comparison Example 1, the outer surrounding surfaces were brought to about 0.18 µm roughness by lapping abrasion, and washed and defatted with tri-chloroethane. A TiN coating having about 7 µm thickness was formed, and was finished by a light lapping. In comparison Example 2, the coating comprised chromium and nitrogen as the main component, and was formed similarly to comparison Example 1.

The piston rings and vanes produced in the Examples and comparison Examples were tested on a practical machine. The results are shown in Tables 4 and 5. The wear resistance of the piston ring and vane produced according to the invention is not inferior to the prior art (comparison Example 1). The durability is good because the coating is thick.

A prior art model having similarly improved durability peeled off its coating, so the material on which the member slides would wear away quickly.

**Table 4**

| The practical machine was a 2800 diesel engine, rotation rate x loading 2500 x 4/4, ran for 100 hours on light oil fuel. | | | | |
|---|---|---|---|---|
| | abrasion loss µm | residual coating thickness | durability | peeling off coating |
| Example 1 | 3 µm | 28 µm | 1033 hr | no |
| Example 2 | 5 µm | 32 µm | 740 hr | no |
| Example 3 | 4 µm | 30 →µm | 1133 hr | no |
| Example 4 | 2 µm | 27 →µm | 1450 hr | no |
| Example 5 | 3 µm | 26 →µm | 966 hr | no |
| Example 6 | 3 µm | 33 →µm | 1233 hr | no |
| Comparison example 1 | 4 µm | 4 →µm | 200 hr | no |
| Comparison example 2 | 3 µm | 30 →µm | 1100 hr | yes |
| ( → means above) | | | | |

**Table 5**

| | | | | |
|---|---|---|---|---|
| Closed type refrigerant compressor refrigerant 1,1,1,2-tetrafluoroethane refrigerating machine oil polyalkyleneglycol system rotation rate 200 rpm running 200 hour | | | | |

| | adrasion loss µm | residual coating thickness | durability | peeling off coating |
|---|---|---|---|---|
| Example 1 | 2 µm | 30 µm | 3200 hr | no |
| Example 2 | 3 µm | 32 pm | 2333 hr | no |
| Example 3 | 2 µm | 31→µm | 3300 hr | no |
| Example 4 | 1 µm | 29 →µm | 6000 hr | no |
| Example 5 | 1 µm | 38 →µm | 5800 hr | no |
| Example 6 | 2 µm | 34 →µm | 3600 hr | no |
| Comparison example 1 | 3 µm | 3 →µm | 400 hr | yes |
| Comparison example 2 | 2 µm | 29 →µm | 3100 hr | yes |
| ( → means above) | | | | |

### The Potential use in the industry

As explained above, the sliding member according to the present invention is valuable in the use for a piston ring in an engine, a mechanical seal and a vane for a rotary compressor due to its excellent durability.

## Claims

1. A sliding member comprising a sand blasted cast iron or steel substrate having a surface roughness of from 2 µm to 8 µm and a coating comprising chromium and nitrogen applied to the substrate by an ion-plating process, the coating having a thickness of 10 µm or more and a surface roughness of 0.8 µm or less.

2. A sliding member according to claim 1 in which the surface roughness of the substrate is from 4 µm to 6 µm.

3. A sliding member according to claim 1 or claim 2 wherein the coating comprises a mixture of metallic chromium and chromium nitride.

4. A sliding member according to claim 1 or claim 2 wherein the coating comprises chromium nitride.

5. A sliding member according to claim 1 or claim 2 wherein the concentration of nitrogen increases continuously or stepwise from the inside to the outer surface of the coating.

6. A sliding member according to any of claims 3 to 5 wherein the coating is amorphous.

7. A method for preparing a sliding member according to any preceding claim which comprises the first step for blasting the substrate surface to a roughness in the stated range, the second step for coating by ion-plating, and the third step for polishing the surface of the coating.

## Patentansprüche

1. Gleitstück mit einem sandgestrahlten Gußeisen- oder Stahlsubstrat mit einer Oberflächenrauhigkeit von 2 µm bis 8 µm und mit einer Chrom und Stickstoff enthaltenden Ummantelung, die auf das Substrat durch ein Ionenbeschichtungsverfahren aufgetragen ist, mit einer Dicke von 10 µm oder mehr und mit einer Oberflächenrauhigkeit von 0,8 µm oder weniger.

2. Gleitstück nach Anspruch 1, bei dem die Oberflächenrauhigkeit des Substrates 4 µm bis 6 µm beträgt.

3. Gleitstück nach Anspruch 1 oder Anspruch 2, bei dem die Ummantelung eine Mischung aus metallischem Chrom oder Chromnitrid aufweist.

4. Gleitstück nach Anspruch 1 oder Anspruch 2. bei dem die Ummantelung Chromnitrid aufweist.

5. Gleitstück nach Anspruch 1 oder Anspruch 2, bei dem die Konzentration des Stickstoffs kontinuierlich oder schrittweise vom Inneren zur äußeren Oberfläche der Ummantelung zunimmt.

6. Gleitstück nach einem der Ansprüche 3 bis 5, bei dem die Ummantelung amorph ist.

7. Verfahren zum Herstellen eines Gleitstücks nach einem der vorhergehenden Ansprüche, mit dem ersten Schritt Strahlen der Substratfläche auf eine Rauhigkeit im angegebenen Bereich, dem zweiten Schritt Ummanteln durch Ionenbeschichtung und dem dritten Schritt Polieren der Oberfläche der Ummantelung.

## Revendications

1. Un élément glissant comprenant un substrat en fonte ou en acier décapé au sable ayant une rugosité de surface allant de 2 µm à 8 µm et un revêtement comprenant du chrome et de l'azote appliqué sur le substrat par un procédé de plaquage ionique, le revêtement ayant une épaisseur de 10 µm ou plus et une rugosité de surface de 0,8 µm ou moins.

2. Un élément glissant suivant la revendication 1 dans lequel la rugosité de surface du substrat va de 4 µm à 6 µm.

3. Un élément glissant suivant la revendication 1 ou la revendication 2 où le revêtement comprend un mélange de chrome métallique et de nitrure de chrome.

4. Un élément glissant suivant la revendication 1 ou la revendication 2 où le revêtement comprend du nitrure de chrome.

5. Un élément glissant suivant la revendication 1 ou la revendication 2 où la concentration d'azote augmente continuellement ou par étapes de l'intérieur vers la surface extérieure du revêtement.

6. Un élément glissant suivant l'une quelconque des revendications 3 à 5 où le revêtement est amorphe.

7. Un méthode pour préparer un élément glissant suivant toute revendication précédente qui comprend la première étape de projection d'abrasifs sur le substrat jusqu'à une rugosité dans la gamme indiquée, la deuxième étape de revêtement par plaquage ionique, et la troisième étape de polissage de la surface du revêtement.
